(19) Europäisches Patentamt
European Patent Office
Office européen des brevets

(11) **EP 1 903 652 A2**

(12) **EUROPÄISCHE PATENTANMELDUNG**

(43) Veröffentlichungstag:
**26.03.2008 Patentblatt 2008/13**

(51) Int Cl.:
***H02H 7/085*** *(2006.01)*

(21) Anmeldenummer: **07016542.8**

(22) Anmeldetag: **23.08.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **21.09.2006 DE 102006044542**

(71) Anmelder: **LuK Lamellen und Kupplungsbau Beteiligungs KG**
**77815 Bühl (DE)**

(72) Erfinder:
• **Kro, Sven-Jostein**
  **4462 Hovsherad (NO)**
• **Gerhart, Jürgen**
  **77767 Appenweier (DE)**

(54) **Verfahren und Schaltung zum Bestimmen des maximalen, von einem Elektromotor aufgenommenen Stroms**

(57) Ein Verfahren zum Bestimmen des maximalen, von einem Elektromotor, insbesondere bei einem EC-Motor, aufgenommen Stroms enthält folgende Schritte:
- kontinuierliches Erfassen der an einem Messwiderstand in der Versorgungsstromleitung des Elektromotors abfallenden Spannung,

- Zuführen der Spannung zu einem Spannungsspeicherbauteil, das die jeweils maximal aufgetretene Spannung speichert,
- Auslesen der jeweils gespeicherten Spannung und
- Rücksetzen des Spannungsspeicherbauteils auf die augenblicklich an ihm liegende Spannung nach einem Auslesen.

Fig. 1

EP 1 903 652 A2

**Beschreibung**

Die Erfindung betrifft ein Verfahren und eine Schaltung zum Bestimmen des maximalen, von einem Elektromotor, insbesondere einem EC-Motor (elektronisch gesteuerter Motor oder elektronisch kommutierter Gleichstrommotor) aufgenommenen Stroms.

Elektromotoren werden in modernen Kraftfahrzeugen in vielfältiger Weise als Aktoren eingesetzt, beispielsweise als Wähl- oder Schaltaktoren in automatisierten Getrieben, als Kupplungsaktoren bei automatischen Kupplungen, wobei beispielsweise in einem Parallelschaltgetriebe zwei Kupplungsaktoren vorgesehen sind, als Fensterhebermotoren usw. Der Messung des von einem solchen Elektromotor aufgenommenen Stroms kommt aus vielerlei Gründen Bedeutung zu.

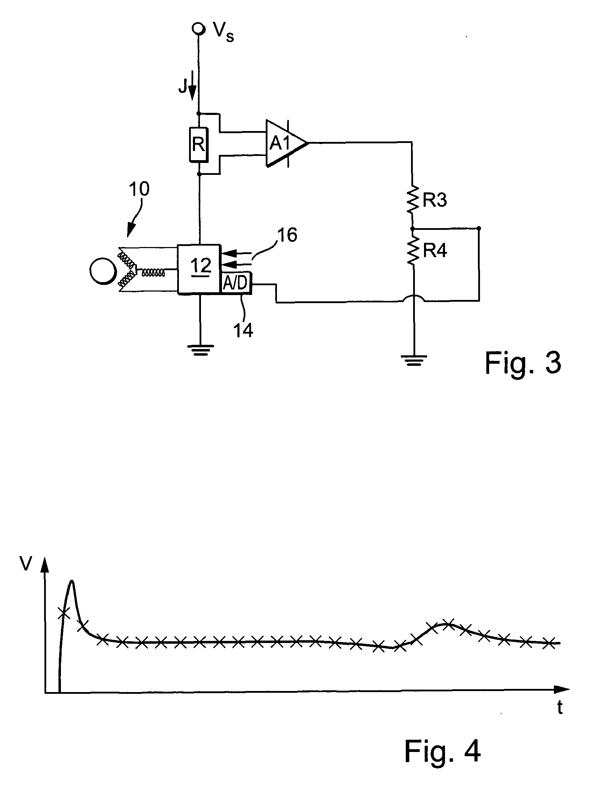

Fig. 3 zeigt ein Blockschaltbild eines EC-Motors mit zugehöriger Strommessung:

Der insgesamt mit 10 bezeichnete EC-Motor wird in an sich bekannter Weise von einem elektronischen Steuergerät 12 gesteuert. Der durch das elektronische Steuergerät fließende Strom I wird mittels eines Shunt- oder Messwiderstandes R gemessen, indem dessen Spannungsabfall über einen Operationsverstärker A1 und gegebenenfalls einen nicht dargestellten Filter und einen Spannungsteiler mit den Widerständen R3 und R4 einem vorzugsweise in das Steuergerät 12 integrierten AD-Wandler 14 zugeführt wird, an dessen weiteren Eingängen 16 für den Betrieb des EC-Motors maßgebliche Signale liegen. Aufbau und Funktion eines EC-Motors und des zugehörigen Steuergerätes sind an sich bekannt und werden daher nicht erläutert.

Das dem Eingang des AD-Wandlers 14 analog zugeführte Stromsignal wird im AD-Wandler 14 digitalisiert und in den Prozessor des Steuergerätes 12 eingelesen. Beispielsweise wird das Stromsignal im Prozessor alle 2,5ms verarbeitet. Somit liegen die Stromwerte im Steuergerät 12 in jedem Regler-Interrupt vor. Der vom Steuergerät 12 aufgenommene Strom ändert sich allerdings aufgrund der elektronischen Kommutierung und der Induktivität der Motorspulen innerhalb der genannten Reglerabtastzeit unter Umständen verhältnismäßig stark, so dass das tatsächlich im Prozessor vorliegende Stromsignal mit einer hohen Ungenauigkeit behaftet ist.

In Fig. 4 ist der Verlauf der analogen, dem Eingang des AD-Wandlers 14 zugeführten Spannung V über der Zeit t beispielhaft dargestellt. Die Abtastzeitpunkte, deren Abstand beispielsweise 2,5ms beträgt, sind durch Kreuze gekennzeichnet. Wie aus der Fig. 4 ersichtlich, hat die konstante Abtastrate folgende Nachteile:

Schnelle Veränderungen des Signals werden bei der dargestellten Abtastrate nicht gemessen. Eine hohe Abtastrate, bei der genau gemessen wird, bedeutet eine hohe Prozessorbelastung und die Verarbeitung großer Datenmengen.

In der Praxis ist es zweckmäßig, den Anfahrstrom von EC-Motoren zu begrenzen, damit die elektronischen Komponenten in dem Steuergerät 12 nicht unnötig groß ausgelegt werden müssen.

Die Strombegrenzung kann entsprechend nachfolgender Gleichung auf eine Spannungsbegrenzung zurückgeführt werden:

$$U\_Motor = Rges*I\_Motor+N\_Motor*2Pi/60*K\_E,$$
wobei

U_Motor: an den Motor angelegte Spannung

Rges: Ohmscher Widerstand der gesamten Wirkkette (Motor und Ansteuerelektronik)

I_Motor: Motorstrom

N_Motor: Motordrehzahl

K_E: Motorkonstante

In der Gleichung werden die Kenngrößen Widerstand Rges sowie Motorkonstante K_E beispielsweise als konstant angenommen. Real unterliegen diese Größen aber aufgrund von Temperatureinflüssen, Fertigungstolleranzen, Alter usw. Streuungen, durch die die Genauigkeit der Strombegrenzung vermindert ist. Gerade die Anfahrströme von Elektromotoren sind sehr hoch, da beim Anfahren die Motordrehzahl zunächst 0 ist und somit keine induzierte Gegenspannung vorliegt. Im Fall der Motordrehzahl 0 lautet die vorgenannte Gleichung:

$$U\_Motor = Rges*I\_Motor$$

Für eine verbesserte Strombegrenzung muss entweder der Widerstand Rges genau bestimmt werden oder aber der Strom I_Motor muss genau gemessen werden.

Der Widerstand kann bestimmt werden, indem die an den Motor angelegte Spannung und der Motorstrom gemessen werden. Auch die Widerstandsmessung steht und fällt somit mit der Genauigkeit der Strommessung. Da sich der Strom bei EC-Motoren aufgrund der Kommutierung und der Induktivität zeitlich sehr rasch ändert, benötigt man entweder eine hohe Abtastfrequenz (>=10kHz), oder man muss z. B. an einen Anschlag fahren, um die Situation Drehzahl = 0 für längere Zeit sicher zu stellen. Erschwerend kommt hinzu, dass die Strommessung mit hohen Toleranzen behaftet ist (beispielsweise +/- 2A über den gesamten Messbereich), so dass mit hohen Strömen gearbeitet werden muss, um eine hohe Genauigkeit zu erhalten. Hohe Ströme aber bedeuten eine hohe Anforderung an die mechanischen Bauteile der Aktoren.

Aus der DE 4203659 A1 ist eine Blockiererkennung von Gleichstrommotoren bekannt, bei der ein Blockieren dadurch erkannt wird, dass ein beim Einschalten des Antriebsmotors auftretender Spitzenstromwert einen vorgegebenen Wert überschreitet. Der Spitzenstromwert wird mit Hilfe einer Sample-and Hold-Schaltung gemessen und als Referenz für die jeweilige Bewegung des Antriebsmotors gespeichert. Die Stromspitze wird mit Hilfe eines Analog-Digitalwandlers gemessen und in einem Mikroprozessor zur Steuerung des Antriebsmotors gespeichert. Die Ermittlung des Spitzenstroms ist wegen des eingesetzten Sample-and-Hold-Verfahrens mit den gleichen Unsicherheiten behaftet, wie anhand der Fig. 3 und 4 erläutert.

Der Erfindung liegt die Aufgabe zugrunde, eine Möglichkeit zu schaffen, den maximalen, von einem Elektromotor, insbesondere einem EC-Motor aufgenommenen Strom zu bestimmen, ohne einen Mikroprozessor stark zu belasten, indem große Datenmengen verarbeitet werden müssen.

Eine Lösung dieser Aufgabe wird mit einem Verfahren zum Bestimmen des maximalen, von einem Elektromotor, insbesondere einem EC-Motor, aufgenommenen Stroms gelöst, das folgende Schritte enthält:

- kontinuierliches Erfassen der an einem Messwiderstand in der Versorgungsstromleitung des Elektromotors abfallenden Spannung,
- Zuführen der Spannung zu einem Spannungsspeicherbauteil, das die jeweils maximal aufgetretene Spannung speichert,
- Auslesen der jeweils gespeicherten Spannung und
- Rücksetzen des Spannungsspeicherbauteils auf die augenblicklich an ihm liegende Spannung nach einem Auslesen.

Vorteilhafterweise wird die gespeicherte Spannung beim Auslesen digitalisiert.

Die ausgelesene und vorzugsweise digitale verfügbare Spannung kann für eine Begrenzung des von dem Elektromotor aufgenommenen Stroms verwendet werden.

Eine Schaltung zum Bestimmen des maximalen, von einem Elektromotor, insbesondere einem EC-Motor aufgenommenen Stroms enthält:

- einen in der Versorgungsstromleitung des Elektromotors liegenden Messwiderstand
- eine mit dem Widerstand verbundene Spannungsspeicherschaltung, die derart aufgebaut ist, dass in ihr die maximale, am Messwiderstand abgefallene Spannung speicherbar ist,
- eine mit der Spannungsspeicherschaltung verbundene Auswertschaltung, in die die in der Spannungsspeicherschaltung gespeicherte Spannung einlesbar ist und
- eine Rücksetzschaltung, mit der die Spannungsspeicherschaltung auf die augenblicklich am Messwiderstand abfallende Schaltung rücksetzbar ist.

Die Spannungsspeicherschaltung enthält vorteilhafterweise einen Kondensator, der mit einem Strombegrenzungswiderstand, mit dem die Aufladezeit des Kondensators eingestellt werden kann, über eine Reihenschaltung mit einer Diode und einem Operationsverstärker verbunden ist.

Die Rücksetzschaltung enthält beispielsweise eine parallel zu dem Kondensator liegende Reihenschaltung aus einem Schalter und einem Widerstand enthält.

Die Erfindung, mit der ein maximaler von einem Elektromotor insbesondere bei dessen Einschalten aufgenommener Strom bestimmt werden kann, eignet sich für weitgehend alle Elektromotoren; insbesondere eignet sie sich für EC-Motoren. Dadurch, dass der maximale von dem Elektromotor bei seinem Einschalten aufgenommene Strom genau vorbestimmt werden kann, kann der dem Elektromotor zugeführte Strom auf einen vorbestimmten Wert (das Anfahren ist dann ggf. verlangsamt) begrenzt werden, wodurch die in der Steuerschaltung des Elektromotors enthaltenen elektronischen Bauteile nicht unnötig stark dimensioniert werden müssen.

Die Erfindung wird im Folgenden anhand schematischer Zeichnungen beispielsweise und mit weiteren Einzelheiten erläutert.

Es stellen dar:

Fig. 1 ein Blockschaltbild eines EC-Motors mit Steuerschaltung und einer erfindungsgemäßen Schaltung zum Bestimmen des Maximalstroms,

Fig.2 einen Verlauf einer an einem Messwiderstand abgenommenen Spannung sowie einer dem Eingang eines AD-Wandlers zugeführten Spannung,

Fig.3 ein Blockschaltbild einer an sich bekannten Schaltung und

Fig.4 einen Verlauf der an einem Messwiderstand mit Abtastzeitpunkten bei konstanten Abtastintervallen.

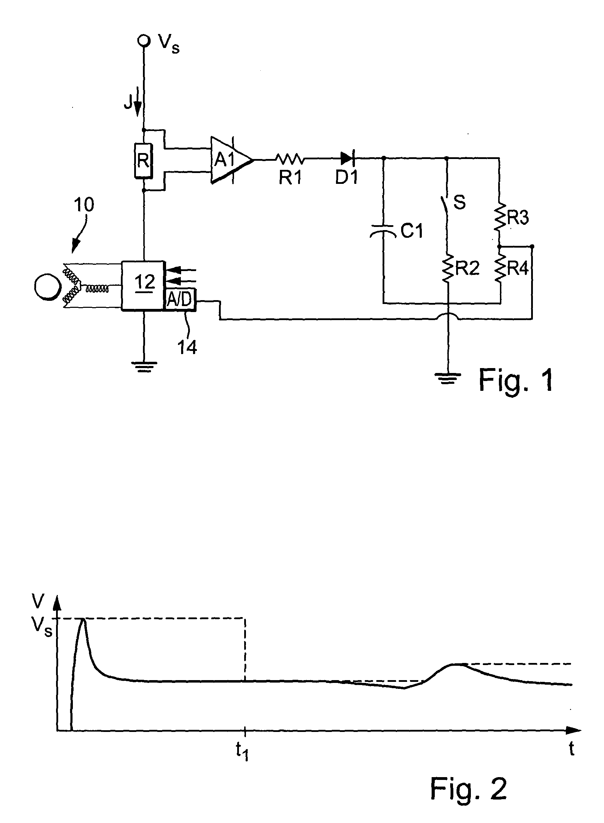

In Fig. 1, deren Schaltung und Bauelemente in großen Teilen mit denen der Fig. 3 übereinstimmen, sind die gleichen Bezugszeichen wie in der bereits erläuterten Fig. 3 verwendet.

Wie ersichtlich, ist der Shunt- bzw. Strommesswiderstand R über den Operationsverstärker A1 nicht direkt mit der Spannungsteilerschaltung (Widerstände R3 und R4) verbunden, sondern dem Ausgang des Operationsverstärkers A1 ist ein Filterwiderstand R1 nachgeschaltet, in Reihe mit dem eine Diode D1 geschaltet ist, die über einen Kondensator C1, parallel dazu über eine Reihnenschaltung aus einem Schalter S und einem Widerstand R2 sowie wiederum parallel dazu über die Spannungsteilerschaltung R3 und R4 mit Masse verbunden ist.

Die Funktion der Schaltung gemäß Fig. 1 ist folgende:

Am Ausgang des Operationsverstärkers A1 liegt eine Spannung, die proportional zum Spannungsabfall am Messwiderstand R und damit vom Elektromotor 10 aufgenommenen Strom ist. Der Kondensator C1 wird von dieser Spannung aufgeladen. Die Spannung wird über den Spannungsteiler R3, R4 ausgelesen. Der Spannungsteiler R3, R4 ist so hochohmig, dass sich der Kondensator C1 beispielsweise innerhalb von 10ms nicht nennenswert entlädt. Die Reset Funktionallität wird über den Schalter S und den Widerstand R2 implementiert. Sobald der Schalter S geschlossen ist, entlädt sich der Kondensator. R2 ist so gewählt, dass sich der Kondensator C1 innerhalb von 10 $\mu$s ganz entladen kann. Die im Kondensator C1 aufgebaute Spannung wird durch die Diode D1 gesperrt, so dass sich der Kondensator nicht über den Pfad mit A1 entladen kann.

Genauer fließt, wenn der Kondensator C1 aufgeladen wird, zunächst ein großer Ladestrom, der durch A1, R1 und den Widerstand der Diode D1 begrenzt wird. Mit zunehmender Aufladung des Kondensators erhöht sich dessen Spannung. Entsprechend sinkt der durch A1, R1 und D1 fließende Strom. Entsprechend sinkt auch der Spannungsabfall an den Bauteilen R1 und D1, so dass bei aufgeladenem Kondensator dessen Spannung gleich der Ausgangsspannung des Operationsverstärkers A1 ist, also proportional dem beim Anfahren des EC-Motors 10 auftretenden Strom-Peak ist.

Fig. 2 verdeutlicht die Situation:

Durchgezogen dargestellt ist der Spannungsverlauf am Ausgang des Operationsverstärkers A1. Infolge der Sperrwirkung der Diode D1 kann sich der Kondensator C1 nicht entladen, so dass dessen Spannung, die durch die gestrichelte Linie dargestellt ist, auf dem Peak-Spitzenwert Vs bleibt, solange der Schalter S geöffnet ist. Die auch bei geöffneten Schalter S mögliche Entladung über die Spannungsteilerschaltung R 3, R4 liegt, wie ausgeführt, in 100ms Bereich, d. h. beeinflusst die Spannung während des dargestellten Zeitintervalls nicht wesentlich. In der Schaltung gemäß Fig. 1 hat der Kondensator C1 bezüglich der Spannung somit eine Peak-Hold Funktion, bei der der größte Wert (Vs) gehalten wird und über den AD-Wandler 14, der mit einer gegenüber der Dauer des Spitzenstroms, die beispielsweise kleiner als 1 ms ist, erhebliche langsameren Taktfrequenz arbeiten kann. Zum Zeitpunkt t1 erfolgt ein Reset, d. h. der Schalter S wird geschlossen, so dass sich der Kondensator C1 über den Widerstand R2 rasch entlädt und die Kondensatorspannung auf den augenblicklichen Wert der Ausgangsspannung des Operationsverstärkers abfällt. Solange die Ausgangsspannung des Operationsverstärkers nicht zunimmt, bleibt die Kondensatorspannung auf diesem Wert und nimmt bei einer Zunahme der Ausgangsspannung des Operationsverstärkers entsprechend der Peak-Hold Funktion wiederum zu.

Es versteht sich, dass die erfindungsgemäße Schaltung in vielfältiger Weise abgeändert werden kann, solange Peak-Hold Funktion mit Reset-Möglichkeit realisiert ist. Der Schalter S ist vorteilhafterweise ein elektronischer Schalter.

Mit der Erfindung ist es möglich, den Maximalwert des Stroms zu speichern und in das Steuergerät einzulesen. Das Einlesen des Stromsignals ist somit unabhängig von dem tatsächlichen Stromverlauf. Außerdem können sehr kurze Stromimpulse erfasst werden, wie sie typischerweise bei einem Anfahrvorgang mit einem EC-Motor vorkommen.

Insgesamt werden folgende Probleme gelöst:

- Es können sehr hohe Ströme gemessen werden, wodurch der Messfehler reduziert wird.
- Zur Messung des Anfahrstroms müssen keine besonderen Fahrsituationen realisiert werden, wodurch die Aktormechanik entlastet wird.
- Bei jedem Anfahren des Elektromotors kann der Gesamtwiderstand R$_{ges}$ bestimmt werden, wenn die folgenden Voraussetzungen gegeben sind:

    ○ Die Spannung muss über die gesamte Messzeit konstant vorliegen und sollte möglichst hoch sein;

    ○ Die Erfassung des Stromsignals muss solange andauern, bis die Induktivität der Motorspule ganz aufgeladen ist.

Beide Voraussetzungen sind bei der geschilderten Messung des Maximalwertes des Motorstroms bei Anfahrvorgängen gegeben.

Die Erfindung kann für alle Arten von mit Elektromotoren insbesondere EC-Motoren, wie sie Getriebeaktoren, beispielsweise bei Kupplungsaktoren, Getriebeaktoren usw. eingesetzt werden.

Die über den AD-Wandler 14 ausgelesene digitalisierte Spannung, die dem Spitzenwert des vom EC-Motor 10 beim Anfahren aufgenommenen Stroms entspricht, kann in unterschiedlichster Weise verwendet werden. Beispielsweise kann ein zulässiger Höchstwert des Spitzenstroms im Steuergerät 12 gespeichert sein und das Anfahren des Elektromotors derart gesteuert werden, dass dieser Höchstwert nicht überschritten wird. Der Schalter S, über den das Rücksetzten erfolgt, ist beispielsweise in das Steuergerät 12 integriert und wird mit vorbestimmter Taktfrequenz oder gesondert gesteuert.

## Bezugszeichenliste

| | |
|---|---|
| 10 | EC-Motor |
| 12 | Steuergerät |
| 14 | AD-Wandler |
| 16 | Eingänge |
| R | Messwiderstand |
| A1 | Operationsverstärker |
| S | Schalter |

**Patentansprüche**

1. Verfahren zum Bestimmen des maximalen, von einem Elektromotor (10), insbesondere einem EC-Motor, aufgenommenen Stroms, enthaltend folgende Schritte:

   - kontinuierliches Erfassen der an einem Messwiderstand (R) in der Versorgungsstromleitung des Elektromotors abfallenden Spannung,
   - Zuführen der Spannung zu einem Spannungsspeicherbauteil (C1), das die jeweils maximal aufgetretene Spannung speichert,
   - Auslesen der jeweils gespeicherten Spannung und
   - Rücksetzen des Spannungsspeicherbauteils auf die augenblicklich an ihm liegende Spannung nach einem Auslesen.

2. Verfahren nach Anspruch 1, wobei die gespeicherte Spannung beim Auslesen digitalisiert wird.

3. Verfahren nach Anspruch 1 oder 2, wobei die ausgelesene Spannung für eine Begrenzung des von dem Elektromotor aufgenommenen Stroms verwendet wird.

4. Schaltung zum Bestimmen des maximalen, von einem Elektromotor (10), insbesondere einem EC-Motor, aufgenommenen Stroms, enthaltend

   - einen in der Versorgungsstromleitung des Elektromotors liegenden Messwiderstand (R),
   - eine mit dem Widerstand verbundene Spannungsspeicherschaltung (D1, C1), die derart aufgebaut ist, dass in ihr die maximale, am Messwiderstand abgefallene Spannung speicherbar ist,
   - eine mit der Spannungsspeicherschaltung verbundene Auswerteschaltung (12, 14), in die die in der Spannungsspeicherschaltung gespeicherte Spannung einlesbar ist, und
   - eine Rücksetzschaltung (S), mit der die Spannungsspeicherschaltung auf die augenblicklich am Messwiderstand abfallende Schaltung rücksetzbar ist.

5. Schaltung nach Anspruch 4, wobei die Spannungsspeicherschaltung (C1, D1) einen Kondensator (C1) enthält, der mit einem Strombegrenzungswiderstand (R1) über eine Reihenschaltung mit einer Diode (D1) und einem Operationsverstärker (A1) verbunden ist.

6. Schaltung nach Anspruch 4 oder 5, wobei die Auswerteschaltung einen A/D- Wandler (14) enthält, dessen Eingang mit dem Kondensator (C1) über eine parallel zum Kondensator liegende Spannungsteilerschaltung (R3, R4) verbunden ist.

7. Schaltung nach einem der Ansprüche 4 bis 6, wobei die Rücksetzschaltung eine parallel zu dem Kondensator liegende Reihenschaltung aus einem Schalter (S) und einem Widerstand (R2) enthält.

Vs

J

R

A1

R1   D1

C1

S

R3

R2   R4

10

12

A/D

14

Fig. 1

V

Vs

t₁

t

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4203659 A1